(19) Europäisches Patentamt
European Patent Office
Office européen des brevets

(11) **EP 3 744 982 A1**

(12) **EUROPEAN PATENT APPLICATION**

(43) Date of publication:
**02.12.2020 Bulletin 2020/49**

(21) Application number: **19211331.4**

(22) Date of filing: **25.11.2019**

(51) Int Cl.:
*F04D 27/00* (2006.01)  *G01R 31/34* (2020.01)
*H02H 7/08* (2006.01)  *H02P 29/02* (2016.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.05.2019  BR 102019011194**

(71) Applicant: **Embraco Indústria de Compressores e Soluções em Refrigeração Ltda.**
**89219-100 Joinville, SC (BR)**

(72) Inventors:
• **SOARES, Claudio Eduardo**
**Santo Antônio, 89218-060 Joinville- SC (BR)**
• **DE SOUZA, Marcos Roberto**
**Costa e Silva, 89218-059 Joinville- SC (BR)**
• **CABRAL, Alexandre**
**Atiradores, 89203-074 Joinville- SC (BR)**

(74) Representative: **Modiano, Micaela Nadia**
**Modiano & Partners**
**Via Meravigli, 16**
**20123 Milano (IT)**

(54) **METHOD AND SYSTEM FOR IDENTIFYING A FAILURE OF A COOLING SYSTEM COMPRESSOR AND COOLING SYSTEM COMPRESSOR**

(57)     The present invention refers to a method and system for identifying a failure in a compressor (4) of a cooling system by means of an implementation of at least a failure identification logic and a braking logic, based on monitoring at least one from between an electrical quantity and a mechanical quantity, comparing these quantities with compatible parameters and possible subsequent braking based on this comparison. The present invention also refers to a cooling system compressor (4) and to a cooling system *per se.*

FIG.1

FIG. 2

**Description**

The present invention refers to a method and system for identifying a failure in a compressor of a cooling system by means of an implementation of at least a failure identification logic and a braking logic, based on monitoring parameters of the cooling system and possible subsequent actuation based on said monitoring. The present invention also refers to a cooling system compressor and a cooling system *per se.*

**DESCRIPTION OF THE STATE OF THE ART**

A power failure in environments endowed with a cooling system is a common occurrence. Inadequate braking or even a lack of braking in such power failure are noted in many cooling system compressors, bringing countless adverse effects to the cooling system and its components, in particular a shock of the mechanical kit on the shell of the compressor.

Additionally, when the load is very high or the voltage is very low, the rotation of the compressor falls to the limit where it is no longer possible to overcome the load of the compression cycle. Then the voltage applied to the engine is switched off and the engine oscillates inside the compressor causing an excessive displacement of the mechanical kit.

PI 1100026-0, for example, describes the application of a braking on a compressor engine following the switch off command, when it is detected that the rotation of the engine shaft is below a given parameter.

Accordingly, this solution proposes the triggering of a controlled deceleration of the shaft of the compressor following the switch off command, stopping the shaft during its last mechanical rotation. However, this solution is not configured to operate when a power failure occurs.

The solution described in US2017254575 is to simplify the design of the springs and suspension system of the compressor in order to prevent the generation of undesirable impacts and noise.

Its idea is to brake the engine and prevent excessive displacement of the mechanical kit during a conventional stoppage in which the energy is withdrawn and the engine will gradually reduce the speed until it stops.

However, this solution depends on a command signal to switch off the engine in an adequate manner, not actuating in the case of failure or power outage, and cannot be applied to identify a potential failure condition, either by high load or by insufficient power, and apply the technique of braking prior to the failure of the compressor.

In turn, although document CN103852625A mentions monitoring the power voltage and the load in order to prevent high currents due to the failure of the engine or very low power voltage, it is not described that the solution monitors the input voltage, the load or the speed of the compressor in order to identify imminent failure and much less that it switches off the compressor by means of a braking process in order to prevent the generation of undesirable impacts or noise.

This being the case, the prior art describes no technology that is configured to identify a power failure and brake the engine even before it topples over.

More specifically, the prior art does not have a solution that acts in the identification of a power outage or imminent failure, thus applying the braking of the engine before failure occurs.

**OBJECTIVES OF THE INVENTION**

An objective of the present invention is to provide a method and system for identifying a failure in a compressor of a cooling system.

An objective of the present invention is to provide a method and system for identifying a failure in a compressor of a cooling system configured to brake an engine of the compressor.

An objective of the present invention is to provide a method and system for identifying a failure in a compressor of a cooling system configured to brake an engine of the compressor when identifying an imminent failure of the compressor.

An objective of the present invention is to provide a method and system for identifying a failure in a compressor of a cooling system configured to brake an engine of the compressor prior to the occurrence (concretization) of failure of the engine of the compressor.

An objective of the present invention is to provide a method and system for identifying a failure in a compressor of a cooling system configured to identify failure both due to a power failure and in the event of high loads.

**BRIEF DESCRIPTION OF THE INVENTION**

The objectives of the present invention are achieved by means of a method for identifying a failure in a compressor of a cooling system by means of an implementation of at least a failure identification logic and a braking logic, in which the failure identification logic chiefly comprises monitoring the parameters of the compressor and the braking logic mainly comprises the braking of the engine of the compressor.

## SUMMARY DESCRIPTION OF THE DRAWINGS

The present invention will now be described in greater detail based on an exemplary embodiment represented in the drawings. The drawings show:

Figure 1 - is a representation of a system configuration for identifying an imminent failure of a compressor in a cooling system according to the present invention;
Figure 2 - is a representation of steps of a method for identifying an imminent failure of a compressor in a cooling system according to the present invention;
Figure 3 - is a graph exemplifying the detection of an imminent failure due to the power outage;
Figure 4 - is a representation of a system configuration for identifying an imminent failure of a compressor in a cooling system according to the present invention, illustrating a measuring of the voltage of the bus in a rectifier with capacitive filter;
Figure 5 - is a representation of a system configuration for identifying an imminent failure of a compressor in a cooling system according to the present invention, illustrating a measuring of the input voltage by way of isolated voltage sensors;
Figure 6 - is a representation of a system configuration for identifying an imminent failure of a compressor in a cooling system according to the present invention, illustrating a measuring of the input voltage in a boost-type converter.

## DETAILED DESCRIPTION OF THE DRAWINGS

Firstly, the present invention refers to a method for identifying a failure in a compressor of a cooling system. The cooling system should preferably be understood as a system configured in appliances and equipment such as fridges, freezers, refrigerators in general both for home use (household appliances) and for commercial use, in which the compressor is configured to be compatible with the characteristics of the method and system that is also the object of the present invention.

In general terms, the present invention is preferably configured by means of implementing at least a failure identification logic and a braking logic, which are described in further detail ahead.

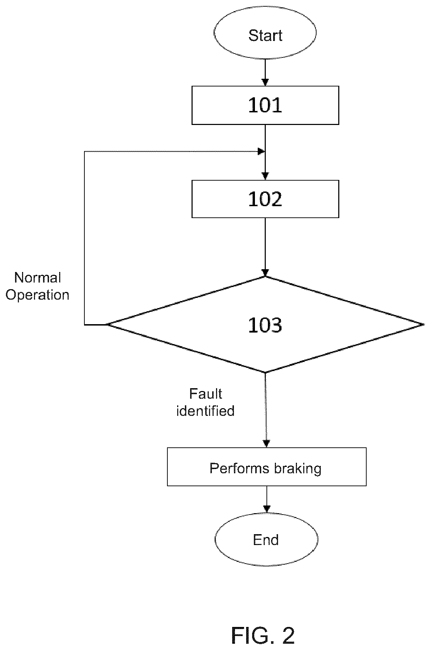

In an arrangement of the present invention, exemplified particularly in figure 2, the failure identification logic comprises a step 101 of obtaining at least a braking enabling set Bes, in which this set is stipulated by a user. Said user may be, for example, a programmer, a manufacturer of the cooling system or of the compressor and its components, a user of the cooling system or of the compressor, among others.

In one arrangement, the braking enabling set Bes is related to a failure identification set Fis and comprises at least one from among a bus voltage limit Vbus_mín, an input voltage limit Vin_mín, a voltage limit applied to the engine Vm_max and an angular speed limit w_mín of the engine.

The braking enabling set Bes is further configured to comprise at least one from between a component obtained as a result of the Vbus voltage and a component obtained as a result of the angular speed w of the engine.

As an example, the braking enabling set Bes is also comprised by the derivative of the angular speed w of the engine in time and by the derivative of the Vbus voltage in time.

Obviously braking enabling set Bes and failure identification set Fis described above may contain additional components, such as torque generated by the engine, current that circulates through the engine, voltage induced by the engine, position of the shaft of the engine, temperatures, pressures and other data that may be requested subsequently, for example.

The failure identification logic further comprises a step 102 of obtaining at least a failure identification set Fis set of the compressor comprised by at least one from between an electrical quantity and a mechanical quantity.

Therefore, as better described ahead, the present invention is configured, for example, to actuate in an optative manner, that is, based on an electrical quantity, a mechanical quantity or both.

Preferably, the failure identification set Fis of the compressor comprises at least one from between a Vbus voltage, a Vin input voltage, a voltage applied to the Vm engine and an angular speed w of the engine.

Endowed with at least one component of each set as mentioned above, in an arrangement the method is configured to perform a step 103 of comparing components of the failure identification set Fis at least with each other and with at least one component from the braking enabling set Bes.

More specifically, as the invention is configured to perform at least a failure identification in a compressor of a cooling system, said comparison is of the type that identifies this failure, such as failure, for example, as better described ahead.

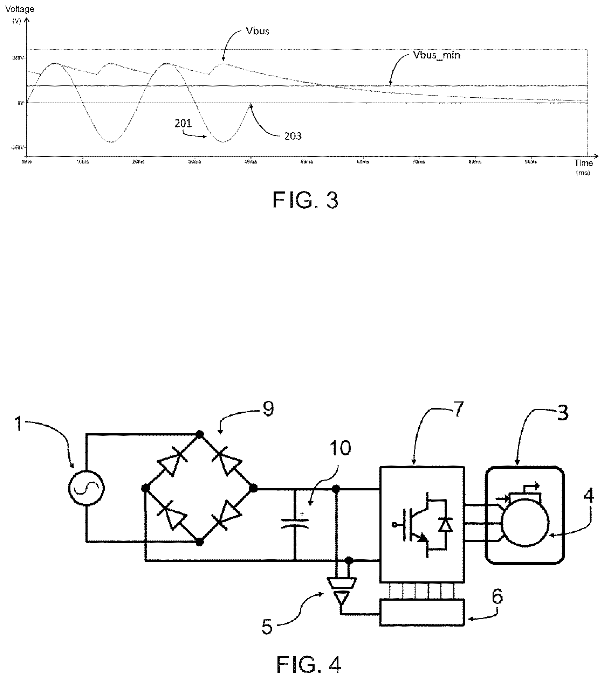

An example of a failure is shown in figure 3, which obviously presents values especially of voltage (V) and time (ms) which should not be interpreted as limitations of the present invention.

In this example, a curve is noted in relation to the phase/neutral voltage 201, a Vbus voltage, a bus voltage limit Vbus_mín and a braking 202 which is performed due to the occurrence of a power outage 203 characterizing a failure.

The failure occurs due to a lack of torque in driving the compressor. When the torque is low, the speed of the engine begins to diminish according to equation 1 below, in which the torque of the engine is represented by Tengine and the torque required by a load is represented by Tload:

$$T_{engine} - T_{load} = \frac{dw}{dt} \qquad \text{(Eq. 1)}$$

It is thus noted that if Tengine < Tload, then dw/dt < 0, that is, the engine is decelerating. This being the case, it is possible to use the speed of the engine w such as a magnitude to monitor the failure of the engine.

It is also possible to analyze both a function related to the speed, such as its derivative, for example, as well as the speed itself, defining a minimum speed below which it is considered that it would no longer be possible to save the engine from imminent failure and thus trigger the braking of the engine prior to failure.

Further, the engine torque Tengine is proportional to an electric current that is applied thereon, as shown in equation 2 below:

$$T_{engine} = kt \cdot i_{engine} \qquad \text{(Eq. 2)}$$

Considering, for example, a driving of the engine by way of a voltage inverter powered by a DC bus, the maximum current managed to be injected in the engine is limited by the voltage of the bus of the Vbus inverter.

It is not possible to apply a current to the engine if the voltage of the bus Vbus is lower than an induced voltage of the engine Eengine.

This ratio is demonstrated by equation 3 below:

$$V_{bus} - E_{engine} = R \cdot i_{engine} \cdot L \frac{di_{engine}}{dt} \qquad \text{(Eq. 3)}$$

This being the case, if the Vbus voltage of the bus diminishes, the current injection capacity into the engine will also diminish and consequently the maximum torque of the engine will diminish as well.

The drop in the torque of the engine may lead to failure as described previously. This being the case, one arrangement enables the Vbus voltage to be monitored in order to predict the failure of the engine, because if the Vbus voltage is very low and/or is diminishing quickly this will bring about the failure of the engine.

The Vbus voltage, in turn, is a function of the input voltage of the electronics and of the load drained by the engine. In the case of a topology of the rectifier bridge type (DC-AC converter), the voltage peak of Vbus is equal to the power voltage peak and its reduction is proportional to the load of the engine at the moment in which the power voltage (AC) is lower than the bus voltage (DC), as shown in the graph of figure 3.

As exemplified in figure 3, in the event of a power outage, the Vbus voltage falls, and so a power outage may be detected via monitoring said Vbus voltage.

Accordingly, the Vbus voltage may also be used to identify a failure in a Vin power voltage directly, which would bring about a failure.

Therefore, one arrangement of the present invention comprises identifying a power failure by measuring the Vin power voltage directly. However, it is noted that this direct measuring requires isolation of the sensor, since the Vin power voltage directly could be at a different potential.

There are various input topologies for converting DC-AD signals. The simplest one is the principle of the rectifier with capacitive filter, compatible with the present invention.

Another possible arrangement comprises a boost-type converter. In this case, it is possible to measure the Vbus voltage and the rectified Vret input voltage in a simple manner without the need for isolation.

It is thus noted that one arrangement that enables the parameters to be monitored may be the Vbus voltage, its rate of change (dVbus/dt), a Vin power voltage directly, the speed of the engine w and its rate of change (dw/dt), as described above.

The failure in the power (Vin = 0 V or very low) could be identified by a very low Vbus associated to a constant drop in the bus voltage (dVbus/dt < 0). A high load could also lead to failure, this could be identified by a very low rotation w associated to a deceleration of the engine (dw/dt < 0).

A good arrangement of the present invention comprises associating the analysis of the Vbus voltage and the analysis of the speed of the engine w in decision-making.

This solution proves to be efficient, because it advantageously prevents unnecessary shutdowns in transient loads that can be recovered through the control action, as will be explained.

In this case, the voltage applied to the engine is added to the analysis, according to equation 4 below:

$$V_m = dc \cdot V_{bus} \qquad (Eq. 4)$$

According to a characteristic of the present invention, a maximum voltage that can be applied to the engine Vm_max is equal to the Vbus voltage. So if the voltage applied to the engine Vm is lower than the Vbus voltage and the Vbus voltage is greater than the induced voltage of the engine Em, it is still possible to recover the speed of the engine by increasing the voltage applied to the engine Vm. Otherwise, it is more advantageous to switch off the engine appropriately by braking prior to failure.

According to that described above, the braking logic of the method of identifying an imminent failure of a compressor in a cooling system is therefore configured to brake the engine of the compressor at least when identifying an imminent failure of the compressor by the failure identification logic described.

In this case, it is noted that the imminent failure is such as a failure and may be identified, consequently, at least when a component of the failure identification set Fis of the compressor exceeds at least a component of the braking enabling set Bes.

Accordingly, the present invention is configured to advantageously identify the failure both due to a failure in the power and in the occurrence of high loads, enabling the failure of the engine to be prevented without applying the specific braking routine.

It is thus possible to foresee failure and to brake the engine before it happens, stopping the compressor adequately without generating noise or over-straining the components and mechanisms of the compressor, such as its suspension and cushioning.

Considering the above, specifically in relation to the step of the method of the present invention which comprises comparing components of the failure identification set Fis at least with each other and with at least a component of the braking enabling set Bes performed by the method of the present invention, it comprises at least one from between the steps described below.

One step of the present method comprises comparing a Vbus voltage to at least one between the bus voltage limit Vbus_mín and an induced voltage in the engine Em.

Mathematically, this step can be described as shown below:

$$V_{bus} < V_{bus\_min} \ \ or \ \ V_{bus} < E_m$$

One step of the present method comprises checking whether there is a constant drop in the Vbus voltage. A possible implementation of this step is, for example, checking whether the derivative of the Vbus voltage in time is lower than a maximum reduction rate of the bus voltage dVbus_max, which characterizes a drop in constant voltage of the Vbus voltage over time.

Mathematically, this step can be described as shown below:

$$\frac{dv_{bus}}{dt} < -\frac{dV_{bus\_max}}{dt}$$

One step of the present method comprises comparing a voltage applied to the engine Vm to at least one between the voltage limit applied to the engine Vm_max and the Vbus voltage.

Mathematically, this step can be described as shown below:

$$V_m = V_{m\_máx} = V_{bus}$$

One step of the present method comprises comparing the angular speed w of the engine to the angular speed limit w_mín of the engine.

Mathematically, this step can be described as shown below:

$$w < w_{min}$$

Another step further comprises checking whether there is deceleration of the engine dw_max.

Mathematically, this step can be described as shown below:

$$\frac{dw}{dt} < -\frac{dw_{max}}{dt}$$

It should be noted that this step is not just a simple comparison with a fixed value, but rather with a configurable value and which can be parameterized, enabling a comparison in accordance with the specific needs of each application of the present invention.

Moreover, considering the two previous steps in particular, the present invention is advantageously configured to present high robustness and prevent as far as possible false detections deriving from transients.

In other words, it is important to note that the comparisons described especially in relation to the Vbus voltage and to the angular speed w, are not carried out with fixed values such as, for example, zero, that is, they are not of the type: dVbus/dt <0 or dw/dt < 0, but are rather compared to dVbus_max and dw_max values that can assume any values.

In another arrangement, checking deceleration of the engine could be carried out based on other magnitudes, such as acceleration for example, where a negative acceleration would characterize a decrease in speed over time (that is, deceleration).

One step of the present method comprises comparing an input voltage Vin to the input voltage limit Vin_mín.

Mathematically, this step can be described as shown below:

$$V_{in} < V_{in\_mín}$$

Considering the steps described above, in light of the method of the present invention, an imminent failure such as failure may be identified when at least one of the following occurs:

- the Vbus voltage is lower than the bus voltage limit Vbus_mín;
- there is a constant drop in the Vbus voltage;
- the angular speed w of the engine is lower than the angular speed limit w_mín of the engine;
- there is constant deceleration of the engine;
- the voltage applied to the Vm engine is equal to at least one from between the voltage limit applied to the engine Vm _max and the Vbus voltage;
- The Vin input voltage is lower than the input voltage limit (Vin_mín).

Preferably, one arrangement considers only the Vbus voltage to detect the failure. Based on the Vbus measuring, its derivative in time dVbus/dt is calculated and a check is made on whether or not failure has occurred, as already described. In theory, there is no need to use information relating to the angular speed w of the engine in identifying the failure, but this arrangement can be implemented and the objectives of the present invention achieved.

When using the angular speed w, it is possible to measure it directly by way of a hall sensor or an encoder, where both can be assembled to the engine and electrically connected to the data-processing unit 6 for measuring said speed.

Another alternative for measuring angular speed w is by measuring the induced voltages of the engine by way of voltage sensors (resistive divider) electrically connected to the phases of the engine and to the data-processing unit 6. In this case, speed w can be estimated by the processing module 6 by way of a mathematical model of the engine which is powered with the phase voltages of the engine.

Another alternative comprises measuring phase currents of the engine, for example by way of current sensors (shunt or inductive) electrically connected to the phases of the engine and to the data-processing module 6, alongside with the voltage to be applied to the engine which is defined by the very data-processing module 6 and applied by the actuation module 7. In this case, speed w can be estimated by the data-processing module 6 by way of a mathematical model of the engine to be powered with the currents and the phase voltages of the engine.

Finally, it is possible to measure the Vin input voltage via a non-isolated voltage sensor (resistive divider) in the case of a boost-type topology or by way of an isolated voltage sensor that would connect the powering unit to the data-processing module.

These configurations are particularly illustrated in figures 4 to 6, which will be better described later.

Bearing in mind the aforementioned checks, the present invention is configured to brake an engine of the compressor in a braking logic, if an imminent failure of the compressor is detected by the failure identification logic.

In reference to the braking *per se*, when anticipating failure, the present invention is configured to advantageously apply an adequate braking procedure, preventing the oscillation of the engine and the excessive displacement of the mechanical kit.

This is possible because the energy used in the braking does not come from an external power source (such as the power line, for example), but rather from the very energy stored in the rotor of the engine at least in the form of kinetic energy.

The braking applied in this case may be: rheostatic or regenerative, both possibilities being compatible with the present invention.

In rheostatic braking, the energy stored in the rotor in the form of kinetic energy is dissipated in the coils of the engine in the form of heat.

In regenerative braking, the energy is transferred to the inverter, that is, the engine thereafter operates as a generator.

Regardless of the form of carrying out braking, provided it is compatible with the principles of the present invention, this should occur up to the stoppage of the engine.

The method described above thus guarantees the anticipation of failure in the engine and the braking thereof prior to the occurrence of this failure.

The present invention further comprises a system for identifying the imminent failure of a compressor in a cooling system.

The system is basically comprised of a powering unit 1, a measuring module 2, a data-processing module 6, an actuation module 7, a compressor 4 and an environment to be cooled 3, in which the measuring module 2 and the data-processing module 6 are electrically connected to each other and compatible with the steps of the method described previously.

In other words, the components of the system of the present invention are configured so as to enable the performance of the steps of the method that is also the object of the present invention.

More specifically, in reference to these components of the present system, the measuring module 2 is configured to obtain at least a failure identification set Fis of the compressor, comprised by at least one between an electrical quantity and a mechanical quantity and configured with the characteristics already described, that is, it comprises at least one from between a Vbus voltage, a Vin input voltage, a voltage applied to the Vm engine and an angular speed w of the engine.

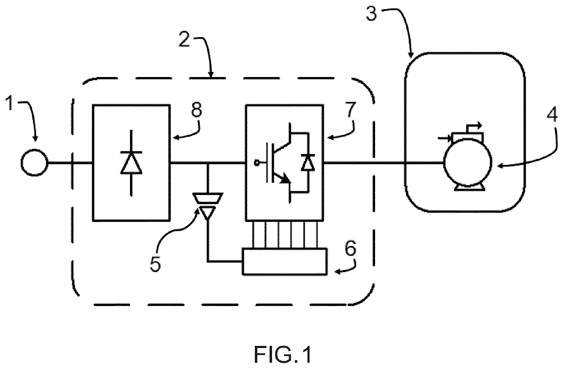

To illustrate a possible arrangement of the measuring module 2, it may comprise a measuring component 5, an actuation module 7, a rectifier 8, 9, a capacitive filter 10 electrically connected to each other, in which the measuring module 2 is still electrically connected to the data-processing module 6, as illustrated mainly in figures 1, 4, 5 and 6.

Figure 1 exemplifies a generic arrangement of the present invention.

It is noted in figure 4 that the measuring component 5 is configured to measure the Vbus voltage in a rectifier 9 with capacitive filter 10. Generally, this measuring component 5 is of the type that performs electrical readings and, as such, is configured as a bus voltage sensor, isolated input voltage sensor, or any other gauge suitable for performing this function.

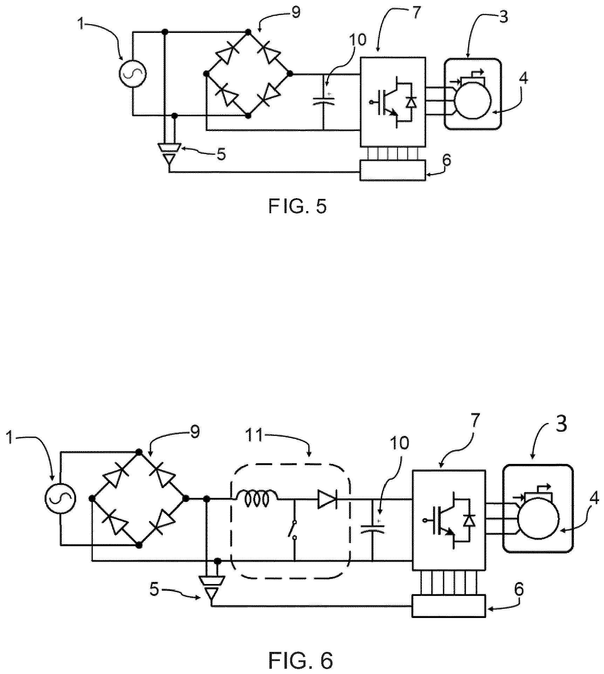

In figure 5, the measuring component 5 is an isolated voltage sensor and configured to measure the Vin input voltage.

In figure 6, the measuring component 5 is configured to measure the Vin input voltage in a boost-type converter 11.

It is important to note that these are merely possible configurations of the present invention, and should not be understood as limitations thereupon. In this sense, other configurations especially of electrical circuits, can be implemented to perform the measuring, evaluation and detection of the cited features.

In turn, the data-processing module 6 is configured to obtain at least a braking enabling set Bes stipulated by a user, in the same way as already described herein.

In short, the braking enabling set Bes is related to the failure identification set Fis and comprises at least one from between a bus voltage limit Vbus_mín, an input voltage limit Vin_mín, a voltage limit applied to the engine Vm_max, an angular speed limit w_mín of the engine and at least a component obtained as a result of the Vbus voltage and at least a component obtained as a result of the angular speed w of the engine such as, for example, a maximum rate of decay of the bus voltage in time (dVbus_max/dt) and a deceleration limit of the engine (dw_max/dt).

Additionally, the data-processing module 6 is also configured to compare components of the failure identification set Fis at least with each other and with at least a component of the braking enabling set Bes.

The data-processing module 6 is further configured to identify an imminent failure, in which the imminent failure is such as failure. This module 6 may identify the imminent failure at least when a component of the failure identification set Fis of the compressor exceeds at least a component of the braking enabling set Bes, as already explained previously.

When this imminent failure (failure) is identified, the actuation module 7 can brake the engine of a compressor 4, that is, braking occurs at least when identifying an imminent failure of the compressor.

More specifically, the data-processing module 6 is configured to perform at least one from among the following steps already described in detail above:

- comparing the Vbus voltage to at least one between the bus voltage limit Vbus_mín and an induced voltage in the engine Em;
- checking whether there is a constant drop in the Vbus voltage;
- comparing the voltage applied to the engine Vm to at least one from between the voltage limit applied to the engine Vm_máx and the Vbus voltage;
- comparing the angular speed w of the engine to the angular speed limit w_mín of the engine;
- checking whether there is constant deceleration of the engine;
- comparing the Vin input voltage to the input voltage limit Vin_mín.

It is important to mention that these steps are similar to those described for the method of identifying an imminent failure of a compressor 4 in a cooling system, such that once the due adaptations are made, the characteristics of the method described are also valid for the present system.

Moreover, the data-processing module is also configured to identify an imminent failure, in which this identification happens when at least one of the following occurs:

- the Vbus voltage is lower than the bus voltage limit Vbus_mín;
- there is a constant drop in the Vbus voltage;
- the angular speed w of the engine is lower than the angular speed limit w_mín of the engine;
- there is constant deceleration of the engine;
- the voltage applied to the engine Vm is equal to at least one from between the voltage limit applied to the engine Vm_max and the Vbus voltage;
- the Vin input voltage is lower than the input voltage limit Vin_mín.

Similarly, it has to be mentioned that these conditions are similar to those described for the method of identifying an imminent failure of a compressor in a cooling system, such that once the due adaptations are made, the characteristics of the method described are also valid for the present system.

In relation to the braking *per se,* the actuation module 7 is configured to perform said braking of the engine of the compressor. In one arrangement, this braking is done using energy originating from the very engine of the compressor, in which the energy is stored in a rotor of the engine at least in the form of kinetic energy.

So, the present invention enables the braking to be carried out in at least a rheostatic or regenerative form, performed up to the stoppage of the engine of the compressor, as already cited.

Finally, the present invention further comprises a cooling system compressor 4 and a refrigerator, both configured with the characteristics previously described and compatible with the method and system now described.

Considering that expounded above, the present invention advantageously achieves its objectives by means of a method and system for identifying a failure in a compressor of a cooling system and cooling system compressor 4.

Accordingly, in accordance with the preceding teachings, the present invention is mainly realized by way of an arrangement that performs the monitoring, for example, of a power voltage (directly or indirectly), of a load (directly by way of torque or power, or indirectly by way of the current) or of the speed (instantaneous or average) and compares these values and/or variations thereof with ceiling values, driving the braking when a condition of imminent failure is established.

In an altogether beneficial way, the present invention is thus configured to brake the engine and prevent the generation of undesirable impacts in conditions of power outage or imminent failure.

Having described an example of a preferred embodiment, it should be understood that the scope of the present invention encompasses other possible variations, and is limited solely by the content of the accompanying claims, potential equivalents being included therein.

**Claims**

**1.** A method for identifying a failure in a compressor (4) of a cooling system by means of an implementation of at least a failure identification logic and a braking logic, the method for identifying a failure in a compressor (4) of a cooling system being **characterized in that** the failure identification logic comprises at least the steps of:

- obtaining at least a braking enabling set (Bes) stipulated by a user;
- obtaining at least a failure identification set (Fis) of the compressor (4) comprised by at least one from between an electrical quantity and a mechanical quantity;
- comparing components of the failure identification set (Fis) at least with each other and with at least a component of the braking enabling set (Bes);

a braking logic comprises at least the step of:

- performing a braking of an engine of the compressor (4);

**in that** the step of performing a braking of an engine of the compressor (4) is carried out at least when identifying an imminent failure of the compressor by the failure identification logic.

2. The method of identifying an imminent failure of a compressor (4) in a cooling system, according to claim 1, **characterized in that** the imminent failure is configured as failure and may be identified at least when a component of the failure identification set (Fis) of the compressor (4) exceeds at least a component of the braking enabling set (Bes).

3. The method of identifying an imminent failure of a compressor (4) in a cooling system, according to claim 2, **characterized in that** the failure identification set (Fis) of the compressor (4) comprises at least one from between a bus voltage (Vbus), an input voltage (Vin), a voltage applied to the engine (Vm) and an angular speed (w) of the engine, and

the braking enabling set (Bes) is related to the failure identification set (Fis) and comprises at least one from among a bus voltage limit (Vbus_mín), a maximum rate of decay (dVbus_max), an input voltage limit (Vin_mín), a voltage limit applied to the engine (Vm_máx), an angular speed limit (w_mín) of the engine and a deceleration limit of the engine (dw_max).

4. The method of identifying an imminent failure of a compressor (4) in a cooling system, according to claim 3, **characterized in that** the braking enabling set (Bes) is further configured to comprise at least one from among a component obtained as a result of the bus voltage (Vbus), a component obtained as a result of the input voltage (Vin) and a component obtained as a result of the angular speed (w) of the engine.

5. The method of identifying an imminent failure of a compressor (4) in a cooling system, according to claim 4, **characterized in that** the step of comparing components of the failure identification set (Fis) at least with each other and with at least a component of the braking enabling set (Bes) comprises at least one from among:

- comparing a bus voltage (Vbus) to at least one from between the bus voltage limit (Vbus_mín) and an induced voltage in the engine (Em);
- checking whether there is a constant drop in the bus voltage (Vbus);
- comparing a voltage applied to the engine (Vm) to at least one from between the voltage limit applied to the engine (Vm_max) and a bus voltage (Vbus);
- comparing the angular speed (w) of the engine to the angular speed limit (w_mín) of the engine;
- checking whether there is deceleration of the engine;
- comparing the input voltage (Vin) to the input voltage limit (Vin_mín).

6. The method of identifying an imminent failure of a compressor (4) in a cooling system, according to claim 5, **characterized in that** the imminent failure may be identified when at least one of the following occurs:

- a bus voltage (Vbus) is lower than the bus voltage limit (Vbus_mín);
- there is a constant drop in the bus voltage (Vbus);
- the angular speed (w) of the engine is lower than the angular speed limit (w_mín) of the engine;
- there is constant deceleration of the engine of the compressor (4);
- the voltage applied to the engine (Vm) is equal to at least one from between the voltage limit applied to the engine (Vm_max) and the bus voltage (Vbus);
- the input voltage (Vin) is lower than the input voltage limit (Vin_mín).

7. The method of identifying an imminent failure of a compressor (4) in a cooling system, according to claim 6, **characterized in that** the energy used to perform the step of braking the engine of the compressor (4) originates from the very engine of the compressor (4), in which the energy is stored in a rotor of the engine of the compressor (4) at least in the form of kinetic energy, and the braking performed is at least one from between rheostatic and regenerative.

8. The method of identifying an imminent failure of a compressor (4) in a cooling system, according to claim 6, **characterized in that** the step of performing the braking of an engine of the compressor (4) is carried out until stoppage of the engine.

9. A system for identifying an imminent failure of a compressor (4) in a cooling system, the system being comprised at least by a powering unit (1), a measuring module (2), a measuring component (5), a data-processing module (6), an actuation module (7) and an environment to be cooled (3), in which the measuring module (2), the measuring component (5), the data-processing module (6) and the actuation module (7) are electrically connected to each other, the system for identifying the imminent failure of a compressor (4) in a cooling system being **characterized in that** the measuring module (2) is configured to obtain at least a failure identification set (Fis) of the compressor (4) comprised by at least one from between an electrical quantity and a mechanical quantity, the data-processing module (6) is configured to obtain at least a braking enabling set (Bes) stipulated by a user and comparing components of the failure identification set (Fis) at least with each other and with at least a component of the braking enabling set (Bes), the actuation module (7) is configured to put on the brake of an engine of the compressor (4) at least when identifying an imminent failure of the compressor (4).

10. A system for identifying an imminent failure of a compressor (4) in a cooling system, according to claim 9, **characterized in that** the data-processing module (6) is configured to identify the imminent failure, in which the imminent failure is such as failure, the data-processing module (6) being configured to identify the imminent failure at least when a component of the failure identification set (Fis) of the compressor (4) exceeds at least a component of the braking enabling set (Bes).

11. The system for identifying an imminent failure of a compressor (4) in a cooling system, according to claim 10, **characterized in that** the failure identification set (Fis) of the compressor (4) comprises at least one from between a bus voltage (Vbus), an input voltage (Vin), a voltage applied to the engine (Vm) and an angular speed (w) of the engine, and
the braking enabling set (Bes) is related to the failure identification set (Fis) and comprises at least one from between a bus voltage limit (Vbus_mín), a maximum rate of decay (dVbus_max/dt), an input voltage limit (Vin_mín), a voltage limit applied to the engine (Vm_máx), an angular speed limit (w_mín) of the engine and a deceleration limit of the engine (dw_max).

12. The system for identifying an imminent failure of a compressor (4) in a cooling system, according to claim 11, **characterized in that** the braking enabling set (Bes) is further configured to comprise at least a component obtained as a result of the bus voltage (Vbus), a component obtained as a result of the input voltage (Vin) and a component obtained as a result of the angular speed (w) of the engine.

13. The system for identifying an imminent failure of a compressor (4) in a cooling system, according to claim 12, **characterized in that** the data-processing module (6) is configured to perform at least one from between:

   - comparing a bus voltage (Vbus) to at least one from between the bus voltage limit (Vbus_mín) and an induced voltage in the engine (Em);
   - checking whether there is a constant drop in the bus voltage (Vbus);
   - comparing a voltage applied to the engine (Vm) to at least one from between the voltage limit applied to the engine (Vm_max) and a bus voltage (Vbus);
   - comparing the angular speed (w) of the engine to the angular speed limit (w_mín) of the engine;
   - checking whether there is deceleration of the engine of the compressor (4);
   - comparing the input voltage (Vin) to the input voltage limit (Vin_mín).

14. The system for identifying an imminent failure of a compressor (4) in a cooling system, according to claim 13, **characterized in that** the data-processing module (6) is configured to identify an imminent failure such as failure when at least one of the following occurs:

- the bus voltage (Vbus) is lower than the bus voltage limit (Vbus_mín);
- there is a constant drop in the bus voltage (Vbus);
- the angular speed (w) of the engine is lower than the angular speed limit (w_mín) of the engine;
- there is constant deceleration of the engine of the compressor (4);
- a voltage applied to the engine (Vm) is equal to at least one from between the voltage limit applied to the engine (Vm_max) and a bus voltage (Vbus);
- a input voltage (Vin) is lower than the input voltage limit (Vin_mín).

**15.** The system for identifying an imminent failure of a compressor (4) in a cooling system, according to claim 14, **characterized in that** the actuation module (7) is configured to perform the braking of the engine of the compressor (4) using energy originating from the very engine of the compressor (4), in which the energy is stored in a rotor of the engine of the compressor (4) at least in the form of kinetic energy, and the braking performed is at least one from between rheostatic and regenerative.

**16.** The system for identifying an imminent failure of a compressor (4) in a cooling system, according to claim 14, **characterized in that** the actuation module (7) is configured to perform a braking of an engine of the compressor (4) until stoppage thereof.

**17.** A cooling system compressor (4), **characterized in that** it is configured as per the method and control system as defined in claims 1 to 16.

**18.** A refrigerator, **characterized in that** it is configured as per the method and control system as defined in claims 1 to 16.

FIG.1

Start

101

102

Normal
Operation

103

Fault
identified

Performs braking

End

FIG. 2

FIG. 3

FIG. 4

FIG. 5

FIG. 6

Europäisches
Patentamt

European
Patent Office

Office européen
des brevets

# EUROPEAN SEARCH REPORT

Application Number

EP 19 21 1331

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/127120 A1 (HAHN GREG [US] ET AL) 12 September 2002 (2002-09-12) * abstract; claims 1-23; figures 1-4 * * paragraph [0007] - paragraph [0010] * * paragraph [0015] - paragraph [0031] * | 1-18 | INV. F04D27/00 G01R31/34 H02H7/08 H02P29/02 |
| X | JP S57 93695 A (HITACHI LTD) 10 June 1982 (1982-06-10) * the whole document * | 1-18 | |
| X | US 2004/174650 A1 (WYATT ARNOLD G [US] ET AL) 9 September 2004 (2004-09-09) * abstract; claims 1-13; figures 1-7 * * paragraph [0006] - paragraph [0008] * * paragraph [0018] - paragraph [0037] * | 1,2,9,10 | |
| X | US 5 546 015 A (OKABE TOYOHIKO [JP]) 13 August 1996 (1996-08-13) * abstract; claims 1-17; figures 1-9 * * column 1, line 54 - column 2, line 24 * * column 2, line 59 - column 7, line 28 * | 1,2,9,10 | |

TECHNICAL FIELDS
SEARCHED      (IPC)

F04D
G01R
H02H
H02P

The present search report has been drawn up for all claims

| Place of search | Date of completion of the search | Examiner |
|---|---|---|
| Munich | 23 June 2020 | Nadal, Rafael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 19 21 1331

This annex lists the patent family members relating to the patent documents cited in the above-mentioned European search report.
The members are as contained in the European Patent Office EDP file on
The European Patent Office is in no way liable for these particulars which are merely given for the purpose of information.

23-06-2020

| Patent document cited in search report | | Publication date | Patent family member(s) | | Publication date |
|---|---|---|---|---|---|
| US 2002127120 | A1 | 12-09-2002 | US | 6406265 B1 | 18-06-2002 |
| | | | US | 2002127120 A1 | 12-09-2002 |
| | | | US | 2005100449 A1 | 12-05-2005 |
| JP S5793695 | A | 10-06-1982 | NONE | | |
| US 2004174650 | A1 | 09-09-2004 | AU | 3075602 A | 24-06-2002 |
| | | | CA | 2431111 A1 | 20-06-2002 |
| | | | EP | 1342304 A2 | 10-09-2003 |
| | | | US | 2002106945 A1 | 08-08-2002 |
| | | | US | 2004174650 A1 | 09-09-2004 |
| | | | WO | 0249178 A2 | 20-06-2002 |
| US 5546015 | A | 13-08-1996 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017254575 A

- CN 103852625 A